# EUROPEAN PATENT SPECIFICATION

(11) **EP 3 041 140 B1**
(45) Date of publication and mention of the grant of the patent: **08.07.2020**
(21) Application number: 15382583.1
(22) Date of filing: 24.11.2015
(51) Int. Cl.: H03K 17/94, H01H 47/22

(54) **Proximity switch**
Näherungsschalter
Commutateur de proximité

(30) Priority: 01.12.2014 EP 14382485
(43) Date of publication of application: 06.07.2016
(73) Proprietor: Hospital Clinic i Provincial de Barcelona, 08036 Barcelona (ES)
(72) Inventor: VILADEVALL I FERRER, Xavier, 08262 Callus (Barcelona) (ES); AGUSTIN BONAGA, Jose Manuel, 08227 TERRASSA (Barcelona) (ES); LOPEZ SILVO, Miguel, Angel, 08227 TERRASSA (Barcelona) (ES); VILA-MASANA I PORTABELLA, Joan, 08036 BARCELONA (ES); RODRÍGUEZ OMEDES, Fernando, 08036 BARCELONA (ES)
(74) Representative: Carpintero Lopez, Francisco

(56) References cited:
- DE-A1- 2 902 443
- US-A- 4 207 466
- US-A- 4 914 539
- US-A- 5 103 085
- US-A- 5 600 552
- US-A1- 2003 160 517
- US-A1- 2011 040 988
- US-A1- 2014 268 474

## Description

The present invention relates to a proximity switch which can control a lamp or any other electric device, allowing contactless operation, by detecting the presence of a nearby object such as the user's hand.

### Background of the Invention

Conventional domestic switches are mechanical switches that do not have any electronic circuit therein. For that reason, they do not need a power supply to operate.

Their wiring is limited to wires necessary for connecting to and disconnecting from the load they control. The simplest type of switch needs only 2 wires and contact of the user's hand with the switch is essential to operate same.

There are also TRIAC-based electronic switches having an electronic circuit therein. These switches are powered by the electric current the lamp consumes or the load they control, and for that reason they can only work while the load is switched on.

This prevents these switches from being able to be operated in a contactless manner because while they are switched off, the control circuit does not receive a power supply and would be unable to detect the presence of the user's hand trying to connect it.

Other infrared switches that control lamps or other loads and are operated in a contactless manner are also known. The control circuit of these switches must permanently receive a power supply regardless of the state of the lamp they control. In these cases, it is essential to add additional cables to the wiring system that would correspond to a conventional switch.

Finally, there are also electronic switches operated in a contactless manner that obtain power supply from rechargeable batteries or cells. This prevents the need for additional wiring but generates the need for frequent maintenance to replace fungible elements.

The need for a proximity switch which can be operated in a contactless manner and does not need cables or additional elements to operate is therefore obvious.

US2003160517A1 discloses an electrical power switch which is a two-terminal electrical power switch having a line-powered switching control mechanism. The electrical power switch is provided with first and second shunt circuits between the terminals of the power outlet. This switch for power to operate through the outlet is included in a first shunt circuit that also contains a power supply operating from current flowing through the switch when in the "ON" condition. This first power supply can power a control means to control the operative state of the switch while current flows through. When the switch is in the "OFF" state, a second power supply contained in a second shunt circuit provides power to the control means.
US5600552 A discloses a DC power supply for an electronic switching element connected in series with a load in an AC main has a rectifying element and a capacitor parallel to the electronic switching element. Charging of the capacitor is provided by opening the switching element and diverting current from the AC main through the rectifying element and capacitor.

### Description of the Invention

The proximity switch of the invention successfully solves the mentioned drawbacks and has other advantages that will be described below.

The proximity switch according to the present invention comprises a relay which can be in an ON state and an OFF state; control means connected with said relay; and a contactless detector detecting the presence of an object close to it for sending a signal to the relay through the control means for switching the relay from the OFF state to the ON state, or vice versa; and the relay, control means and detector are electrically powered by means of a power supply network when the relay is in the ON state and when it is in the OFF state.

Advantageously, the proximity switch according to the present invention also comprises a voltage regulator providing continuous power supply to the relay, control means and detector.

Furthermore, said voltage regulator is preferably connected to a current transformer, powering the voltage regulator when the relay is in the ON state, and said voltage regulator is preferably connected to a voltage transformer, powering the voltage regulator when the relay is in the OFF state.

Preferably, the current transformer is connected with said relay, and the voltage transformer is connected with input terminals for supplying power to said relay.

According to a preferred embodiment, the relay is a bistable electromagnetic relay and the detector is an infrared detector. Said infrared detector detects the presence of an object preferably by means of pulse trains and triangulation for measuring the distance between the object and the detector.

Furthermore, the proximity switch according to the present invention also advantageously comprises a voltage zero-crossing detector connected to said control means which allow the relay state change at optimal times.

A voltage rectifier is preferably arranged between the current transformer and voltage regulator and/or between the voltage transformer and voltage regulator.

If desired, the proximity switch according to the present invention can also comprise a pilot light connected with said control means and/or an indicator light connected with said control means.

Optionally, the proximity switch can also comprise a data transfer connector connected to said control means.

Advantageously, said control means are a microcontroller.

The present invention is a switch that overcomes the limitations of switches existing today since it can be operated in a contactless manner and does not need additional cables to operate because the power supply is obtained from the same wires that would correspond to a conventional switch.

In the switch according to the present invention, the power supply necessary for the operation of the electronic control circuit is obtained from the actual electric power supplied to the lamp or load.

According to an embodiment, said power supply network can comprise an electronic circuit formed by semiconductors, which advantageously comprises a Zener power diode connected to said relay. Said electronic circuit can also comprise a MOSFET transistor connected in parallel to the Zener power diode and to the control means.

The use of an electronic circuit formed completely by semiconductors allows greater energetic efficiency and a lower cost to be obtained, while expanding the power range of the lamps which the switch can control.

As a result of the absence of contact with the switch, cleanliness is assured and the risk of fouling or contamination is eliminated. The invention allows use thereof with wet or dirty hands, since the electronic circuit can be hermetically isolated without jeopardizing operation. Furthermore, the possibility of being installed in existing boxes having standard mechanisms without having to modify the wiring, make it very suitable for replacing conventional switches in sensitive clinic or hospital settings.

### Brief Description of the Drawings

To better understand the foregoing, drawings are attached in which a practical embodiment is schematically depicted only by way of non-limiting example.
Figure 1 is a block diagram of the components of the proximity switch according to the present invention according to an example not forming part of the present invention.
Figure 2 is a block diagram of the electronic circuit of the power supply network which is used in an embodiment of the proximity switch according to the present invention.

### Description of a Preferred Embodiment

The proximity switch comprises a relay 3 which can be in an ON state and an OFF state, control means 2 connected with said relay 3; and a contactless detector 1 detecting the presence of an object close to it for sending a signal to the relay 3 through the control means 2 for switching the relay 3 from the OFF state to the ON state, or vice versa.

The switch is preferably used for switching a lamp on and off.

In the switch according to the present invention, contactless operation is achieved by means of said detector 1, preferably an infrared detector, detecting the infrared radiation reflected by a nearby object, such as the user's hand.

The detector 1 is associated with filters to assure that the detector 1 is not influenced by infrared light in the environment or by infrared radiation emitted by other common devices (remote controls for televisions, air conditioning systems, etc.). For example, the infrared radiation is emitted in pulse trains, which assures that the detector is not affected by other similar switches that may be located nearby.

The infrared detector 1 works by triangulation and measures the distance at which the object is located. The detector 1 is calibrated to react to objects located at least 5 cm away, for example.

The lamp is controlled by means of said relay 3, which is preferably a bistable electromechanical relay. The fact that it is an electromechanical relay instead of a TRIAC or solid-state relay allows covering all cases of simple switches or cross-point switches. It is even possible to combine conventional switches with the switches of this invention in one and the same installation since the wiring is the same.

The fact that the relay 3 is bistable and not monostable reduces power consumption to limits that are compatible with self-powered operation. Unlike a conventional monostable relay, a bistable relay has two stable states (ON and OFF), such that it does not require a power supply to maintain any of the two states. Power supply is only necessary when switching between the two states corresponding to the time when switching on or off.

The bistable relay 3 incorporated in the switch of the present invention has two coils which can be activated individually. Once the corresponding coil is activated, the relay 3 will maintain its state indefinitely, even though current passage through its coil ceases.

This operation reduces power consumption with respect to the consumption of a conventional relay and allows limiting the size of the current transformer so that it fits in the available volume.

The power supply of the electronic control circuit, including the detector 1, relay 3 and control means 2, formed by a microcontroller, for example, is obtained by means of the power supply from the cables connected to the power network connecting with the lamp.

There are two different operating principles depending on the state of the lamp:
- ON cycle (the lamp is on):
   In this case, the current circulating through the lamp also goes through the relay 3 of the switch, and it is also circulated through the primary circuit of a current transformer 5 integrated in the switch. This generates a current in the secondary circuit which is proportional to the current of the primary circuit and powers the control circuit (detector 1, microcontroller 2 and relay 3). The current in the primary circuit must be less than the maximum current that the circuit can withstand in order to not destroy same, but it must also be greater than the minimum necessary so that the control circuit receives enough power supply. These two values determine the acceptable current range of the lamp which allows the switch to work correctly.

This current transformer 5 is connected to a voltage regulator 4 generating a continuous power supply of 5 volts, for example. A voltage rectifier-balancer 7 is arranged between the current transformer 5 and voltage regulator 4.
- OFF cycle (the lamp is off):
   In this case, the current transformer 5 does not generate any current in its secondary circuit since there is no current in the primary circuit. The voltage that would be applied to the lamp is in the terminals of the relay 3 because the circuit is open. The power supply of the control circuit is obtained, in this case, by means of a voltage transformer 6 connected to the terminals of the relay 3. It is of interest to note that this voltage transformer 6 does not generate any voltage in the ON cycle, since in that case the relay 3 is closed and voltage between its terminals is 0.

The primary circuit of the voltage transformer 6 is connected to the terminals of the relay 3. An AC voltage is generated in the secondary circuit, said voltage being rectified and filtered through a rectifier 8 before being sent to the voltage regulator 4, generating a continuous power supply of 5 volts, for example.

The switch according to the present invention also comprises a voltage zero-crossing detector 9 which is preferably formed by two diodes and two resistances, extracting a signal from the secondary circuit which allows the microcontroller 2 to detect voltage zero-crossing.

This voltage zero-crossing detection allows using the switch according to the present invention with inductive loads.

When the lamp is off, the relay 3 will be connected at the time of voltage zero-crossing, which will coincide with the intensity zero-crossing, and when the lamp is on, the relay 3 will be disconnected at the time of current zero-crossing.

A relay is an electromechanical device and therefore has certain inertia. Disconnection of the terminals of the relay does not occur immediately when the relay receives the activation current pulse in the coil, but will take some time which can be of a few milliseconds. Given that the wave half-period of a 220-V AC supply voltage is 10 ms (at 50 Hz), the time delay of the relay is very significant. The microcontroller 2 is calibrated to take this into account and to advance the activation signal for disconnection at the time of zero-crossing.
- Switching between cycles:
   In some types of lamps, the current does not immediately reach its maximum value upon connection, but takes some time to stabilize. To assure power supply in these cases, the switch incorporates capacitors (not depicted in the drawings) accumulating the necessary power.

The microcontroller 2 of the electronic control circuit comprises the connections necessary for detecting current and voltage zero-crossing. This allows connecting and disconnecting the relay at optimal times, such that resistive loads (incandescent light bulbs, stoves, etc.) as well as inductive loads (fluorescent tubes, transformers, motors, etc.) can be controlled.

The switch is designed for being adapted to existing boxes having standard mechanisms and advantageously comprises an indicator light (LED) 11 that lights up briefly to indicate that the user's hand has been detected. It also comprises a pilot light (LED) 10 to facilitate positioning thereof in the absence of light.

The switch can also comprise a standard USB connector 12 which optionally allows connecting it to a computer for programming operating parameters.

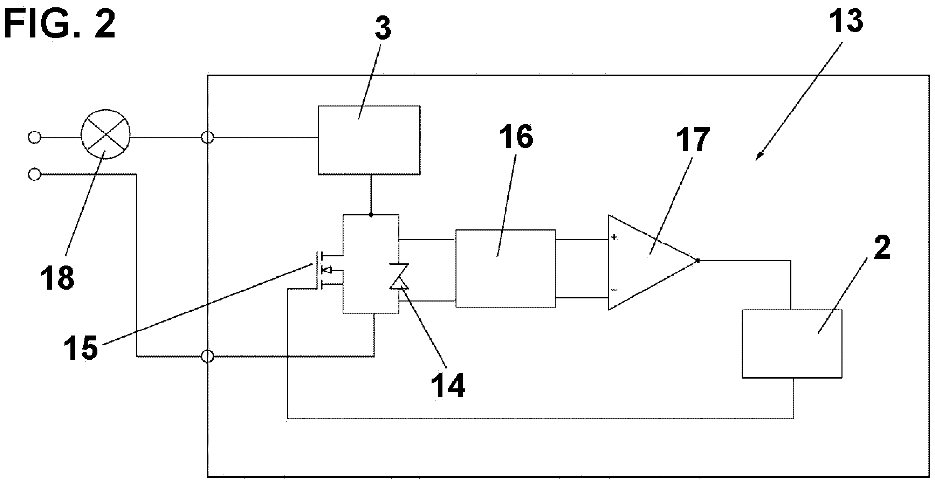

According to an embodiment, the power supply network comprises the electronic circuit 13 which is shown in figure 2. This electronic circuit 13 is integrally formed by semiconductors and comprises a Zener power diode 14, a MOSFET transistor 15, a rectifier and filter 16 and a comparator 17, as is described below.

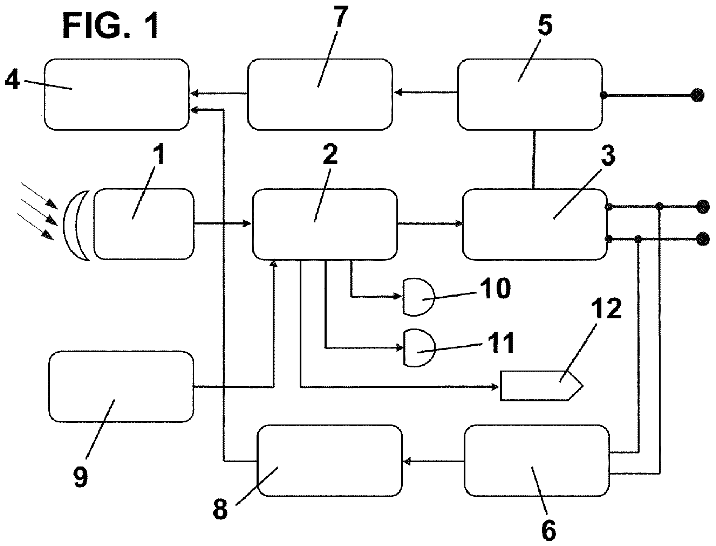

According to this embodiment, the ON and OFF cycles are the following:
- ON cycle (the lamp is on)
   In this case, the current which circulates through the lamp 18 also passes through the relay 3 of the device and through a Zener power diode 14. Due to the fact that the current is alternating, the polarization of the Zener power diode 14 changes alternately between direct and inverse polarization with a frequency of 50 cycles per second. In the direct polarization half-waves, the Zener diode 14 acts as a normal diode and therefore drives the current, producing a small drop in voltage (approximately 0.7 volts). In the inverse polarization half-waves, the Zener diode 14 also drives, however, producing a greater drop in voltage (approximately 7.5 volts). The total effect is that the lamp 18 is turned on normally, and a voltage in the terminals of the Zener 14 is achieved, which is subsequently rectified and filtered to obtain the supply voltage for the circuit 13. Due to the losses which are produced in the Zener, this system would also be useful in practice for low-power lamps since lamps with high power would cause total loss due to overheating of the Zener 14. In order for the system to function with lamps with greater power, the circuit also includes a MOSFET transistor 15 in parallel with the Zener 14 and control means 2 which form a commuted power source capable of generating the supply voltage with high-power lamps securely and efficiently.
- OFF cycle (the lamp is off):
   In this case, the Zener diode 14 does not generate any voltage in the terminals thereof, since no current circulates through the same. The voltage of 220 V which would be applied to the lamp 18 appears in the terminals of the relay 2 since the circuit is open. The supply of the control circuit is obtained, in this case, by means of a voltage transformer 6 (figure 1) connected to the terminals of the relay.

The commutation between cycles is not described for this embodiment since it is carried out in the same manner as in the example.

It should be indicated that the switch according to the present invention allows wireless communication to be carried out using NFC (Near Field Communication) technology with another emitting or receiving device. NFC is an open platform intended for connecting a mobile telephone to this device, with the aim of parameterizing operating options such as for example enabling or disabling the function of an LED, enabling or disabling the presence sensor, modifying the OFF state timing in the case of the presence detector function being enabled, etc. and all from a mobile device with an application programmed for said functions which pairs both devices.

Furthermore, the switch according to the present invention can also comprise a programmable timer, for operating time in the case of the ON state of the lamp being actuated. The timer can be in ON mode or in OFF mode.

Although reference has been made to a specific embodiment of the invention, it is obvious for a person skilled in the art that the proximity switch that has been described is susceptible to a number of variations and modifications, and that all the mentioned details can be replaced with other technically equivalent details, without departing from the scope of protection defined by the attached claims.

## Claims

1. Proximity switch comprising:
- a relay (3) which can be in an ON state and an OFF state;
- control means (2) connected with said relay (3); and
- a contactless detector (1) detecting the presence of an object close to it for sending a signal to the relay (3) through the control means (2) for switching the relay (3) from the OFF state to the ON state, or vice versa;
the relay (3), the control means (2) and the detector (1) being electrically powered by means of a power supply network when the relay (3) is in the ON state and when it is in the OFF state,
wherein said power supply network comprises an electronic circuit (13) formed by semiconductors,
the proximity switch also comprising a lamp (18), and alternating current which circulates through the lamp (18) also passes through the relay (3) and through a Zener power diode (14), so that the polarization of the Zener power diode (14) changes alternately between direct and inverse polarization, and in the direct polarization half-waves, the Zener power diode (14) acts as a normal diode and drives the current, producing a drop in voltage, and in the inverse polarization half-waves, the Zener power diode (14) also drives producing a greater drop in voltage, so that the lamp (18) is turned on,
and in that wherein said electronic circuit also comprises a MOSFET transistor (15) connected in parallel to the Zener power diode (14) and to the control means (2),
**characterized in that**:
the MOSFET transistor (15) in parallel with the Zener power diode (14) and the control means (2) included in the electronic circuit (13) form a commuted power source;
the relay (3) is a bistable electromagnetic relay; and
the proximity switch also comprises a voltage zero-crossing detector (9) connected to said control means (2).

2. Proximity switch according to claim 1, wherein the power supply network comprises a voltage regulator (4) providing continuous power supply to the relay (3), the control means (2) and the detector (1).

3. Proximity switch according to claim 1, wherein the detector (1) is an infrared detector.

4. Proximity switch according to claim 3, wherein the infrared detector (1) detects the presence of an object by means of pulse trains and triangulation for measuring the distance between the object and the detector (1).

5. Proximity switch according to claim 1, also comprising a pilot light (10), an indicator light (11) and/or a data transfer connector (12) connected with said control means (2).

## Patentansprüche

1. Näherungsschalter, welcher Folgendes umfasst:
- ein Relais (3), welches sich in einem EIN-Zustand und einem AUS-Zustand befinden kann;
- ein Steuermittel (2), das mit dem Relais (3) verbunden ist; und
- ein kontaktloser Detektor (1), der die Gegenwart eines Objektes in seiner Nähe zum Senden eines Signals an das Relais (3) durch das Steuermittel (2) zum Schalten des Relais (3) aus dem AUS-Zustand in den EIN-Zustand oder umgekehrt erkennt;
wobei das Relais (3), das Steuermittel (2) und der Detektor (1) mittels eines Stromversorgungsnetzes elektrisch betrieben werden, wenn sich das Relais (3) in dem EIN-Zustand befindet und wenn es sich in dem AUS-Zustand befindet,
wobei das Stromversorgungsnetz eine elektronische Schaltung umfasst (13), die durch Halbleiter gebildet wird,
wobei der Näherungsschalter auch eine Lampe (18) umfasst, und ein Wechselstrom, der durch die Lampe (18) fließt, auch durch das Relais (3) und durch eine Zener-Leistungsdiode (14) fließt, sodass die Polarisation der Zener-Leistungsdiode (14) abwechselnd zwischen einer direkten und einer inversen Polarisation wechselt, und bei den Halbwellen der direkten Polarisation die Zener-Leistungsdiode (14) als eine normal Diode agiert und den Strom antreibt, wodurch ein Spannungsabfall erzeugt wird, und bei den Halbwellen der inversen Polarisation die Zener-Leistungsdiode (14) auch die Erzeugung eines größeren Spannungsabfalls antreibt, sodass die Lampe (18) eingeschaltet wird, und
wobei die elektronische Schaltung auch einen MOSFET-Transistor (15) umfasst, der parallel zu der Zener-Leistungsdiode (14) und zu dem Steuermittel (2) geschaltet ist,
**dadurch gekennzeichnet, dass**:
der MOSFET-Transistor (15) parallel zu der Zener-Leistungsdiode (14) und dem Steuermittel (2), enthalten in der elektronischen Schaltung (13), eine kommutierte Stromquelle bilden;
das Relais (3) ein bistabiles elektromagnetisches Relais ist; und
der Näherungsschalter auch einen Spannungsnulldurchgang-Detektor (9) umfasst, der an das Steuermittel (2) angeschlossen ist.

2. Näherungsschalter nach Anspruch 1, wobei das Stromversorgungsnetz einen Spannungsregler (4) umfasst, der eine kontinuierliche Stromversorgung an das Relais (3), das Steuermittel (2) und den Detektor (1) bereitstellt.

3. Näherungsschalter nach Anspruch 1, wobei der Detektor (1) ein Infrarotdetektor ist.

4. Näherungsschalter nach Anspruch 3, wobei der Infrarotdetektor (1) die Gegenwart eines Objektes mit Hilfe von Impulsfolgen und Triangulation zum Messen der Distanz zwischen dem Objekt und dem Detektor (1) erkennt.

5. Näherungsschalter nach Anspruch 1, welcher auch eine Kontrollleuchte (10), eine Anzeigeleuchte (11) und/oder einen Datenübertragungsanschluss (12) umfasst, die/der mit dem Steuermittel (2) verbunden ist.

## Revendications

1. Commutateur de proximité comprenant :
- un relais (3) qui peut être dans un état activé (ON) et un état désactivé (OFF) ;
- des moyens de commande (2) connectés audit relais (3) ; et
- un détecteur sans contact (1) détectant la présence d'un objet proche de lui pour envoyer un signal au relais (3) par l'intermédiaire des moyens de commande (2) pour commuter le relais (3) de l'état désactivé à l'état activé, ou inversement ;
le relais (3), les moyens de commande (2) et le détecteur (1) étant alimentés électriquement au moyen d'un réseau d'alimentation électrique quand le relais (3) est dans l'état activé et quand il est dans l'état désactivé,
dans lequel ledit réseau d'alimentation électrique comprend un circuit électronique (13) formé par des semiconducteurs,
le commutateur de proximité comprend également une lampe (18) et un courant alternatif qui circule à travers la lampe (18) passe également à travers le relais (3) et à travers une diode Zener de puissance (14), de manière que la polarisation de la diode Zener de puissance (14) change par alternance entre une polarisation directe et inverse et, dans les demi-ondes de polarisation directe, la diode Zener de puissance (14) agit comme une diode normale et conduit le courant, produisant une chute de tension, et, dans les demi-ondes de polarisation inverse, la diode Zener de puissance (14) conduit également en produisant une plus grande chute de tension, de manière que la lampe (18) soit allumée,
et dans lequel ledit circuit électronique comprend également un transistor MOSFET (15) connecté en parallèle à la diode Zener de puissance (14) et aux moyens de commande (2),
**caractérisé en ce que** :
le transistor MOSFET (15) en parallèle avec la diode Zener de puissance (14) et les moyens de commande (2) inclus dans le circuit électronique (13) forment une source d'alimentation commutée ;
le relais (3) est un relais électromagnétique bistable ; et
le commutateur de proximité comprend également un détecteur de passage par zéro de la tension (9) connecté auxdits moyens de commande (2).

2. Commutateur de proximité selon la revendication 1, dans lequel le réseau d'alimentation électrique comprend un régulateur de tension (4) fournissant une alimentation électrique continue au relais (3), aux moyens de commande (2) et au détecteur (1).

3. Commutateur de proximité selon la revendication 1, dans lequel le détecteur (1) est un détecteur infrarouge.

4. Commutateur de proximité selon la revendication 3, dans lequel le détecteur infrarouge (1) détecte la présence d'un objet au moyen de trains d'impulsions et d'une triangulation pour la mesure de la distance entre l'objet et le détecteur (1).

5. Commutateur de proximité selon la revendication 1, comprenant également une veilleuse (10), un témoin lumineux (11) et/ou un connecteur de transfert de données (12) connectés auxdits moyens de commande (2).
